# EUROPEAN PATENT APPLICATION

(11) **EP 2 447 391 A2**
(43) Date of publication of application: **02.05.2012**
(21) Application number: 12152250.2
(22) Date of filing: 19.12.2006
(51) Int. Cl.: C23C 4/12, C23C 28/00, C23C 4/04, C23C 4/08, C23C 4/18, C25D 3/50, C25D 5/12, C25D 11/00, C25D 5/48

(54) **High strength Ni-Pt-Al-Hf bondcoat**

(30) Priority: 21.12.2005 US 316635
(62) Divisional of application: 06256431.5
(71) Applicant: United Technologies Corporation, Hartford, CT 06101 (US)
(72) Inventor: Kasule, Asumini, New Britain, CT 06053 (US)
(74) Representative: Hoffmann, Benjamin

(57) **Abstract**

A turbine engine component has a substrate (10) formed from a nickel based superalloy and a Ni-Pt-Al-Hf bondcoat (14,16) applied to a surface of the substrate. Two methods for forming the platinum modified Ni-Pt-Al-Hf bondcoat (14,16) are described herein.

## Description

### BACKGROUND OF THE INVENTION

### (1) Field of the Invention

The present invention relates to a high strength nickel-platinum-aluminum-hafnium bondcoat for a turbine engine component and a method for forming same.

### (2) Prior Art

Turbine engine components are subjected to elevated temperatures as a result of their exposure to high temperature gas. Such exposure can lead to the creation of unwanted defects in the components. To protect the components, bondcoats and/or ceramic topcoats are applied to the surfaces of the turbine engine components.

Despite the existence of such coatings, there is still a need for coatings which provide the components with improved oxidation resistance.

### SUMMARY OF THE INVENTION

Accordingly, the present invention is directed to an improved coating system for a turbine engine component and methods for forming same.

In accordance with the present invention, there is provided a method for forming a coating on a substrate. The method broadly comprises the steps of providing a substrate, depositing a layer of platinum onto a surface of the substrate, depositing a nickel-aluminum-hafnium (Ni-Al-Hf) layer onto the platinum layer, and heat treating the substrate with the deposited layers to form a nickel- platinum-aluminum-hafnium (Ni-Pt-Al-Hf) bondcoat.

In accordance with the present invention, there is provided an alternative method for forming a coating on a substrate. The method broadly comprises the steps of providing a substrate, depositing a Ni-Al-Hf layer onto a surface of the substrate, depositing a layer of platinum over the Ni-Al-Hf layer, and heat treating the substrate with the deposited layers to form a Ni-Pt-Al-Hf bondcoat.

In accordance with the present invention, there is provided a turbine engine component broadly comprising a substrate formed from a nickel based superalloy and a Ni-Pt-Al-Hf bondcoat applied to a surface of the substrate.

Other details of the high strength Ni-Pt-Al-Hf bondcoat of the present invention, as well as other advantages attendant thereto, are set forth in the following description and the accompanying drawings wherein like reference numerals depict like elements.

### BRIEF DESCRIPTION OF THE DRAWINGS

FIG. 1 is a schematic representation of a first coating system in accordance with the present invention; and
FIG. 2 is a schematic representation of a second coating system in accordance with the present invention.

### DETAILED DESCRIPTION OF THE PREFERRED EMBODIMENT(S)

As discussed, the present invention is directed to an improved coating system that can be applied to turbine engine components, such as vanes, blades, and seals, that are exposed to high temperature gases. The coating system includes a thin bondcoat that offers oxidation protection to the nickel based superalloy forming the turbine engine component. The bondcoat is a high strength Ni-Pt-Al-Hf coating. The addition of the platinum to the bondcoat improves the adherence of the aluminum oxide scale that forms during use of the turbine engine component.

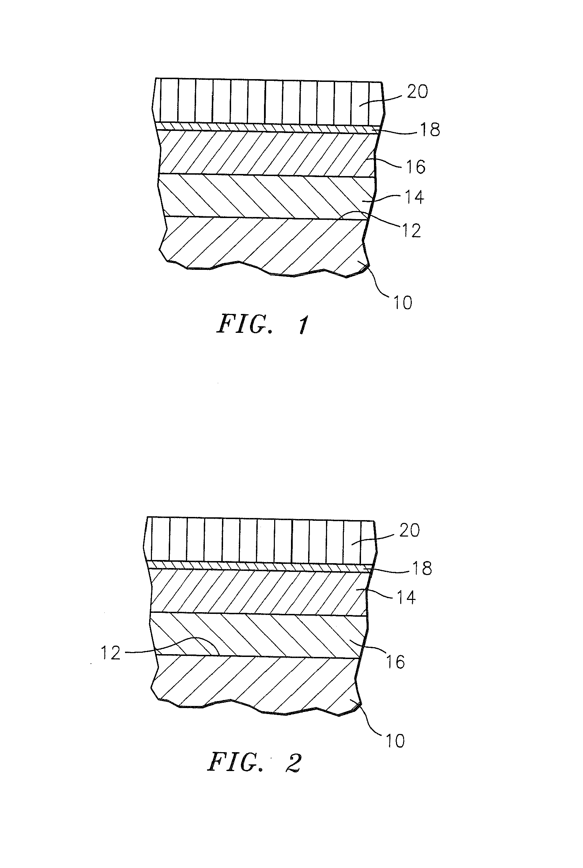

FIG. 1 illustrates a first sequence for forming a coating system in accordance with the present invention. As shown therein, a nickel based alloy substrate 10 has a surface 12. A layer 14 of platinum is deposited onto the surface 12, preferably using an electroplating technique. For purposes of illustration only, a useful electroplating bath may contain platinum quantities in the range of 17 to 26 grams/liter. The current density may range from 20 to 30 amps per square foot. The time for electroplating will be determined by the required thickness. The electroplating bath temperature can go up to 200 degrees F (93°C). The layer of electroplated platinum may have a thickness in the range of from about 0.01 to 1.0 mils (0.00025 mm - 0.025 mm). These electroplating parameters are offered merely for purposes of illustration as other electroplating parameters can be employed. The platinum layer also can be deposited by techniques other than electroplating, such as including, but not limited to sputtering, and other deposition techniques.

Thereafter, a layer 16 of Ni-Al-Hf material is deposited onto the platinum layer. Preferably, the Ni-Al-Hf material is deposited using a cathodic arc deposition process. Techniques for applying the coatings of the present invention by cathodic arc plasma vapor deposition are discussed in U.S. Patent Nos. 5,972,185; 5,932,078; 6,036,828; 5,792,267; and 6,224,726, all of which are incorporated by reference herein. Alternate methods of deposition, including other plasma vapor deposition techniques such as magnetron sputtering and electron beam plasma vapor deposition may be used. When thickness concerns are not present, various thermal spray techniques such as low pressure plasma spray and HVOF (high velocity oxy-fuel) techniques may be utilized. The Ni-Al-Hf material which is deposited may have a composition consisting of about from about 5.5 to 15.0 wt%, preferably from about 5.5 to 13.5 wt%, aluminum, from about 0.001 to 5.0 wt%, preferably from about 0.001 to 0.4 wt%, hafnium, and the balance nickel.

Following deposition of the Ni-Al-Hf material, the substrate 10 with the deposited layers 14 and 16 is subjected to a diffusion heat treatment. The diffusion heat treatment is carried out at a temperature in the range of from about 1200 to about 2100 degrees Fahrenheit (649 - 1149°C) for a time period in the range of from about 2.0 to 15 hours. The diffusion treatment is preferably carried out in an inert gas atmosphere such as an argon atmosphere. The fully heat treated Ni-Pt-Al-Hf bondcoat may have a thickness in the range of from about 1.0 to 5.0 mils (0.025 - 0.127 mm) and a composition consisting of from about 5.0 to 70 wt%, preferably 10 to 60 wt% platinum, 5.5 to 15 wt%, preferably from 5.5 to 13.5 wt%, aluminum, 0.001 to 5.0 wt%, preferably from 0.001 to 0.4 wt% hafnium, and the balance nickel.

Once the bondcoat is formed, a ceramic topcoat 20 may be applied using any suitable ceramic composition known in the art. A preferred composition for the ceramic topcoat 20 is yttria stabilized zirconia such as 7.0 wt% yttria stabilized zirconia. Other favorite compositions include zirconia based pyrochlores, 5 to 60 mol% gadolinia stabilized zirconia, and zirconia stabilized with various lanthanide sesquioxides and mixtures thereof as described in U.S. Patent No. 6,730,422, which is incorporated by reference herein. The ceramic topcoat layer 20 may have a thickness in the range of from about 1.0 to 50 mils (0.025 - 1.27 mm), preferably from 3.0 to 15 mils (0.076 - 0.381 mm).

The ceramic topcoat 20 may be applied using any suitable deposition technique known in the art. A preferred deposition, technique is electron beam physical vapor deposition (EB-PVD). Ceramic coatings are preferably applied to bondcoated substrates at substrate temperatures ranging from 1700 to 2200 degrees Fahrenheit (927 - 1204°C), and chamber pressures of 0.1 to 1.0 millitorr. Deposition time ranges from 20 to 120 minutes using feedstock feedrates of 0.2 to 1.5 inches (5.1 - 38.1 mm) per hour. Other suitable deposition techniques include thermal spraying, chemical vapor deposition, and other physical vapor deposition techniques, including, but not limited to, cathodic arc deposition, sputtering, and thermal evaporation. Either an inert or reactive atmosphere can optionally be used in all of these deposition techniques as known to be appropriate by one skilled in the art.

When produced by vapor deposition techniques, the ceramic topcoat layer 20 is characterized by a columnar grained microstructure with the columnar grains or columns being oriented substantially perpendicular to the surface 12. The columnar grains or columns extend outwardly from the bondcoat or from an aluminum oxide scale layer 18 that is intentionally formed on the bondcoat before or during deposition of the ceramic layer 20. In addition, vapor deposition techniques that utilize means to increase the mobility of vapor species on the substrate surface, such as substrate bias or high-energy ion impingement, result in dense equiaxed ceramic coatings. Alternatively, thermally sprayed coatings that form by depositing liquid droplets on the substrate have a porous microstructure consisting of randomly piled frozen splats of liquid, These splats are typically microcracked and typically trap pores between them, resulting in a strain-tolerant microstructure.

Referring now to FIG. 2, there is shown an alternative sequence for forming a coating system in accordance with the present invention. In this method, the bondcoat is formed by depositing the Ni-Al-Hf layer 16 onto the surface 12 of the substrate and then depositing the platinum layer 14 over the Ni-Al-Hf layer 16. The Ni-Al-Hf layer may have the same composition as described above and may be deposited using the technique described above. The platinum layer 14 may have the same compositional range as described above and may be deposited using the electroplating technique described above. The diffusion heat treatment step is performed after the platinum depositing step using the same parameters as described above. The preferred bondcoat thickness is the same as that discussed in the prior method. The ceramic topcoat layer 20 may be deposited as discussed above.

Several specimens coated in accordance with the present invention have survived greater than 1000 hours of cyclic oxidation in a burner rig at temperatures in excess of 2000 degrees Fahrenheit (1093°C).

## Claims

1. A turbine engine component comprising:
a substrate (10) formed from a nickel based superalloy; and
a Ni-Pt-Al-Hf bondcoat applied to a surface (12) of said substrate (10).

2. A turbine engine component according to claim 1, wherein said bondcoat has a thickness in the range of from 1.0 to 5.0 mils (0.025 - 0.127 mm).

3. A turbine engine component according to claim 1 or 2, wherein said bondcoat has a composition consisting of from about 5.0 to 70 wt% platinum, from about 5.5 to 15 wt% aluminum, from about 0.001 to 5.0 wt% hafnium, and the balance nickel.

4. A turbine engine component according to claim 3, wherein said platinum is present in an amount from about 10 to 60 wt%, said aluminum is present in an amount from about 5.5 to 13.5 wt%, said hafnium is present in an amount from about 0.001 to 0.4 wt%.

5. A turbine engine component according to any of claims 1 to 4, further comprising a ceramic topcoat (20) and a layer of aluminum oxide scale (18) between said ceramic topcoat (20) and said bondcoat, whereby said bondcoat improves adherence of said aluminum oxide scale.

6. A turbine engine component according to claim 5, wherein said ceramic topcoat (20) comprises a yttria stabilized zirconia.

7. A turbine engine component according to claim 5, wherein said ceramic topcoat comprises a zirconia based pyrochlore topcoat.

8. A turbine engine component according to claim 5, wherein said ceramic topcoat (20) comprises an about 5 to 60 mol% gadolinia stabilized zirconia topcoat.

9. A turbine engine component according to any of claims 5 to 8, wherein said ceramic topcoat (20) has a thickness in the range of from 1.0 to 50 mils (0.025 - 1.27 mm).

10. A turbine engine component according to claim 9, wherein said thickness in the range of from 3.0 to 15 mils (0.076 - 0.381 mm).

11. A turbine engine component according to any of claims 5 to 10, wherein said ceramic topcoat (20) has a columnar grained microstructure with columnar grains oriented substantially perpendicular to the surface (12) of the substrate (10) and extending outwardly from the bondcoat and an alumina scale layer (18).
